# EUROPÄISCHE PATENTANMELDUNG

(11) **EP 0 537 419 A1**
(43) Veröffentlichungstag der Anmeldung: **21.04.1993**
(21) Anmeldenummer: 92111317.1
(22) Anmeldetag: 03.07.1992
(51) Int. Cl.: H01L 43/04

(54) **Anordnung mit einem integrierten Magnetfeldsensor sowie einem ferromagnetischen ersten und zweiten Magnetfluss-Konzentrator und Verfahren zum Einbau einer Vielzahl von Anordnungen in je einem Kunststoffgehäuse**

(30) Priorität: 09.10.1991 CH 2979/91
(71) Anmelder: Landis & Gyr Business Support AG, CH-6301 Zug (CH)
(72) Erfinder: Popovic, Radivoje, CH-6300 Zug (CH); Hrejsa, Jan, CH-6317 Oberwil (CH)

(57) **Zusammenfassung**

In einer Variante der Anordnung sind die beiden Magnetfluss-Konzentratoren (18, 19) jeweils ein Teil von zwei ferromagnetischen Leadframes. Ein Teil (18b) eines ersten Magnetfluss-Konzentrators (18), der Halbleiter-Chip (4) und ein Teil (19b) eines zweiten Magnetfluss-Konzentrators (19) bilden ein drei Schichten (I, II, III) aufweisendes sandwichförmiges Bauteil (18b;4;19b). Ein weiterer Teil (18a) des ersten Magnetfluss-Konzentrators (18) ist ein treppenstufenförmiges Blechteil, welches ein erstes und ein zweites Flächenteil (22, 23) aufweist, die beide parallel versetzt angeordnet sind. Das erste Flächenteil (22) ist mit einer Seite auf dem Halbleiter-Chip (4) aufliegend in einer ersten Schicht (I) angeordnet. Das zweite Flächenteil (23) und der Halbleiter-Chip (4) sind in einer zweiten Schicht (II) angeordnet. Ein Teil (17) eines nichtferromagnetischen Leadframes, auf dem der Halbleiter-Chip (4) montiert ist, und der zweite Magnetfluss-Konzentrator (19) sind in einer dritten Schicht (III) angeordnet. Die Anordnung ist ohne Schwierigkeiten mit einer Standard-Montagelinie montier- und verpackbar, wobei bei der Montage teure Justierarbeiten und die Entstehung von relativ grossen und ungenauen Luftspalten vermieden werden.

## Beschreibung

Die Erfindung bezieht sich auf eine Anordnung mit einem in einem Halbleiter-Chip integrierten Magnetfeldsensor sowie einem ferromagnetischen ersten und zweiten Magnetfluss-Konzentrator gemäss dem Oberbegriff des Anspruchs 1 und auf ein Verfahren zum Einbau einer Vielzahl von Anordnungen in je einem Kunststoff-Gehäuse.

Die Anordnung dient vorzugsweise dem Messen eines Magnetfeldes H, welches in unmittelbarer Nähe der Oberfläche des Halbleiter-Chips vorhanden ist.

Eine Anordnung der im Oberbegriff des Anspruchs 1 genannten Art ist aus der Druckschrift "Technisches Messen tm 56 (1989) 11, Seiten 436 bis 443, Aufbautechniken für Halbleiter-Magnetfeldsensoren, W. Heidenreich" bekannt. Die dort dargestellte Magnetfeldsensor-Anordnung ist als Hybridschaltung aufgebaut, in der der eine Magnetfluss-Konzentrator ein Ferrit-Substrat und der andere Magnetfluss-Konzentrator ein Ferritwürfel ist, der auf ein Hallkreuz eines Hallelementes aufgeklebt ist.

Der Erfindung liegt die Aufgabe zugrunde, die bekannte Anordnung so zu verbessern, dass sie ohne Schwierigkeiten mit einer bei der Herstellung integrierter Schaltungen üblicherweise verwendeten Standard-Montagelinie montiert und verpackt werden kann unter gleichzeitiger Vermeidung von teuren Justierarbeiten bei der Montage sowie relativ grossen und ungenauen Luftspalten, die bei Hybridschaltungen in der Regel vorhanden sind und die Empfindlichkeit des Magnetfeldsensors negativ beeinflussen.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

Ausführungsbeispiele der Erfindung sind in der Zeichnung dargestellt und werden im folgenden näher beschrieben.

Es zeigen:
- Fig. 1: eine bekannte, einen Magnetfeldsensor enthaltende Messanordnung,
- Fig. 2: einen bekannten mechanischen Aufbau eines in einem Kunststoff-Gehäuse eingebauten integrierten Magnetfeldsensors,
- Fig. 3: eine Draufsicht eines Ausschnitts aus einem bekannten, zur Massenherstellung von integrierten Hallelementen verwendeten Leadframes mit mehreren montierten Halbleiter-Chips,
- Fig. 4: einen Querschnitt durch eine vereinfachte schematische Darstellung einer ersten Variante der erfindungsgemässen Anordnung,
- Fig. 5: eine Draufsicht der vereinfachten schematischen Darstellung der ersten Variante der erfindungsgemässen Anordnung,
- Fig. 6: einen Querschnitt durch eine vereinfachte schematische Darstellung einer zweiten Variante der erfindungsgemässen Anordnung,
- Fig. 7: eine Draufsicht der vereinfachten schematischen Darstellung der zweiten Variante der erfindungsgemässen Anordnung,
- Fig. 8: einen Querschnitt durch eine vereinfachte schematische Darstellung einer dritten Variante der erfindungsgemässen Anordnung,
- Fig. 9: eine Draufsicht der vereinfachten schematischen Darstellung der dritten Variante der erfindungsgemässen Anordnung,
- Fig. 10: eine Draufsicht sowie drei Querschnitte G-H, K-L und M-N einer detaillierten Darstellung der zweiten Variante der erfindungsgemässen Anordnung anlässlich ihrer Montage und Verpackung,
- Fig. 11: eine Draufsicht einer vereinfachten schematischen Darstellung einer vierten Variante der erfindungsgemässen Anordnung,
- Fig. 12: einen Querschnitt durch die vereinfachte schematische Darstellung der vierten Variante der erfindungsgemässen Anordnung,
- Fig. 13: eine Draufsicht einer vereinfachten schematischen Darstellung einer fünften Variante der erfindungsgemässen Anordnung und
- Fig. 14: einen Querschnitt durch die vereinfachte schematische Darstellung der fünften Variante der erfindungsgemässen Anordnung.

Gleiche Bezugszahlen bezeichnen in allen Figuren der Zeichnung gleiche Teile.

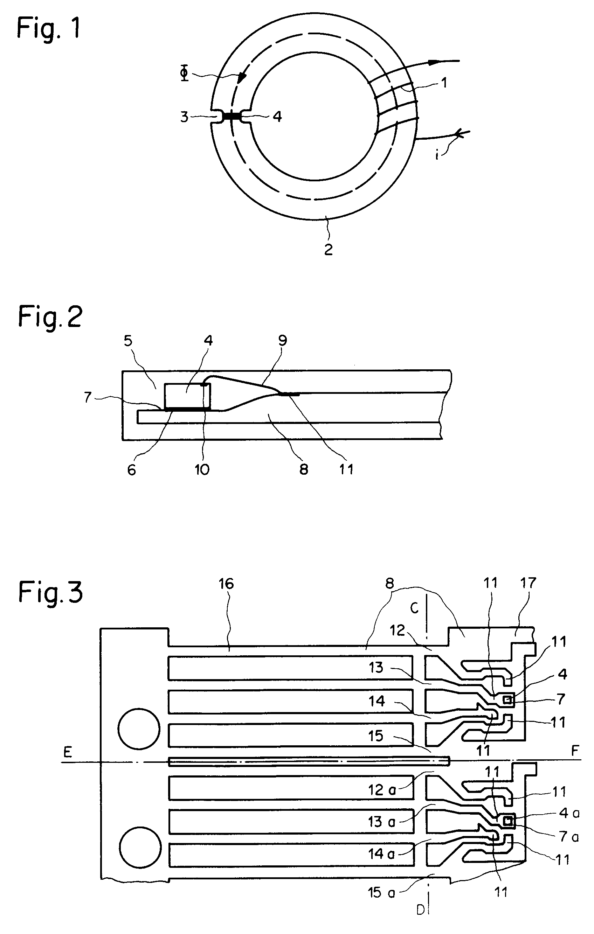

Ein zu messendes Magnetfeld H wird z. B. gemäss einer Darstellung in der Fig. 1 mit Hilfe einer von einem Wechselstrom i durchflossenen Spule 1, die um einen ferromagnetischen Kern 2 gewickelt ist, in einem Luftspalt 3 des letzteren erzeugt. Der Wechselstrom i generiert dabei im ferromagnetischen Kern 2 einen Magnetfluss Φ. Ein Halbleiterplättchen, in dem ein Magnetfeldsensor integriert ist, wird nachfolgend als Halbleiter-Chip 4 bezeichnet und ist im Luftspalt 3 des ferromagnetischen Kerns 2 angeordnet. Die Abmessungen des Querschnitts des letzteren sind in der Regel bedeutend grösser als die entsprechenden parallelen Abmessungen des Halbleiter-Chips 4. Aus diesem Grund werden bei Präzisions-Messungen vorzugsweise die beiden luftspaltseitigen Enden des ferromagnetischen Kerns 2 je mit einem in der Fig. 1 nichtdargestellten z. B. trichterförmigen Magnetfluss-Konzentrator aus ferromagnetischem Material versehen. Die beiden Magnetfeld-Konzentratoren konzentrieren den im ferromagnetischen Kern 2 vorhandenen Magnetfluss Φ auf je eine relativ kleine magnetfeldempfindliche Fläche des Halbleiter-Chips 4. Der Magnetfeldsensor ist vorzugsweise ein Hallelement.

In der Fig. 2 ist ein aus der Integriertenschaltungs-Technik bekannter mechanischer Aufbau eines in einem Kunststoff-Gehäuse 5 eingebauten Halbleiter-Chips 4 dargestellt. Der Halbleiter-Chip 4 ist mittels eines Klebers 6, eines Schweissvorgangs oder eines Lötvorgangs auf eine zugehörige Fläche 7 eines Anschlussträgerbands montiert und befestigt, welches nachfolgend als Leadframe 8 bezeichnet wird und aus blechförmigem metallischem Material besteht. Das letztere ist z. B. wie Kupfer elektrisch gut leitend oder mit einer elektrisch gut leitenden Schicht z. B. aus Silber bedeckt. Ausserdem sind als Bond-Drähte bezeichnete Verbindungsdrähte 9 vorhanden, die vorzugsweise feine Golddrähte sind. Die Verbindungsdrähte 9 sind, z. B. mittels Thermokompression, jeweils an einem ersten ihrer beiden Enden mit einer an der Oberfläche des Halbleiter-Chips 4 vorhandenen Kontaktfläche 10 und an einem zweiten ihrer beiden Enden mit einer Kontaktfläche 11 des Leadframes 8 elektrisch gut leitend verbunden. Nach der Montage des Halbleiter-Chips 4 auf dem Leadframe 8 und nach Anschluss der Verbindungsdrähte 9 wird das so realisierte Gebilde z. B. in Kunststoff vergossen zwecks Realisierung des Kunststoff-Gehäuses 5.

In der Praxis werden zur Massenproduktion von integrierten Schaltungen auf einem Leadframe 8, der dann die Gestalt eines länglichen Blechstreifens besitzt, eine Vielzahl gleicher Halbleiter-Chips 4 montiert. In der Fig. 3 ist ein Teil der Draufsicht eines Leadframes 8 dargestellt, in dem zwei Flächen 7 und 7a sichtbar sind, auf denen je einer von zwei Halbleiter-Chips 4 und 4a montiert ist. Die Verbindungsdrähte 9 sind wegen der zeichnerischen Klarheit in der Fig. 3 nicht dargestellt. Sie sind jedoch bei jedem Halbleiter-Chip 4 bzw. 4a vorhanden. Wenn der Halbleiter-Chip 4 bzw. 4a nur ein Hallelelement enthält, dann sind, wie in der Fig. 3 dargestellt, vier äussere Anschlüsse pro Halbleiter-Chip 4 bzw. 4a vorhanden, nämlich zwei Strom-Eingangsanschlüsse und zwei Sensor-Ausgangsanschlüsse. Wenn jeder Halbleiter-Chip 4 bzw. 4a in einem bekannten DIL-Gehäuse ("Dual in line"-Gehäuse) montiert wird, dann hat jeder der vier äusseren Anschlüsse des Halbleiter-Chips 4 bzw. 4a die Gestalt eines Anschlussbeins 12, 13, 14 oder 15 bzw. 12a, 13a, 14a oder 15a, die innerhalb des Leadframes 8 elektrisch gut leitend mit je einer Kontaktfläche 11 des Leadframes 8 verbunden sind. Die Kontaktflächen 11 und die Anschlussbeine 12 bis 15 sowie 12a bis 15a werden mit allen ihnen zugehörigen, im Leadframe 8 vorhandenen elektrischen Verbindungen hergestellt, z. b. indem die zwischen ihnen vorhandenen Leerräume aus dem Blechstreifen, aus der der Leadframe 8 hergestellt ist, herausgestanzt oder herausgeätzt werden.

Nachdem alle auf dem Leadframe 8 montierten und mit Anschlussdrähten 9 versehenen Halbleiter-Chips 4, 4a, usw., mit je einem Kunststoff-Gehäuse 5 versehen sind, wird ein nicht mehr benötigter Teil 16 des Leadframes 8 entlang einer Schnittlinie CD abgeschnitten. Gleichzeitig werden die einzelnen verpackten Halbleiter-Chips 4, 4a, usw. entlang mehrerer Schnittlinien EF mechanisch voneinander getrennt. In der Darstellung der Fig. 3 befindet sich der nicht mehr benötigte Teil 16 des Leadframes 8 links von der Schnittlinie CD, während ein pro Halbleiter-Chip in der verpackten Anordnung verbleibender und damit zur Anordnung gehörender Teil 17 des Leadframes 8 rechts von der Schnittlinie CD dargestellt ist. Die Schnittlinie CD verläuft dabei annähernd entlang einem äusseren Rand der Anschlussbeine 12 bis 15 und 12a bis 15a, während die Schnittlinie EF dagegen zwischen zwei benachbarten Anordnungen senkrecht zur Schnittlinie CD verläuft.

Im Halbleiter-Chip 4 bzw. 4a sind in der Regel zusätzlich zum Magnetfelsensor bzw. Hallelement noch andere elektronische Bauelemente vorhanden, die alle zusammen z. B. eine integrierte Schaltung bilden. In diesem Fall sind meistens mehr als vier Anschlussbeine 12 bis 15 bzw. 12a bis 15a pro Halbleiter-Chip 4 bzw. 4a vorhanden. Dabei sind dann vorzugsweise alle Anschlussbeine in zwei parallelen Reihen nebeneinander angeordnet. Bei der so erhaltenen verpackten Anordnung werden schliesslich noch alle Anschlussbeine um 90° gebogen zwecks Realisierung der bei einem DIL-Gehäuse üblichen Anschlussbeinen.

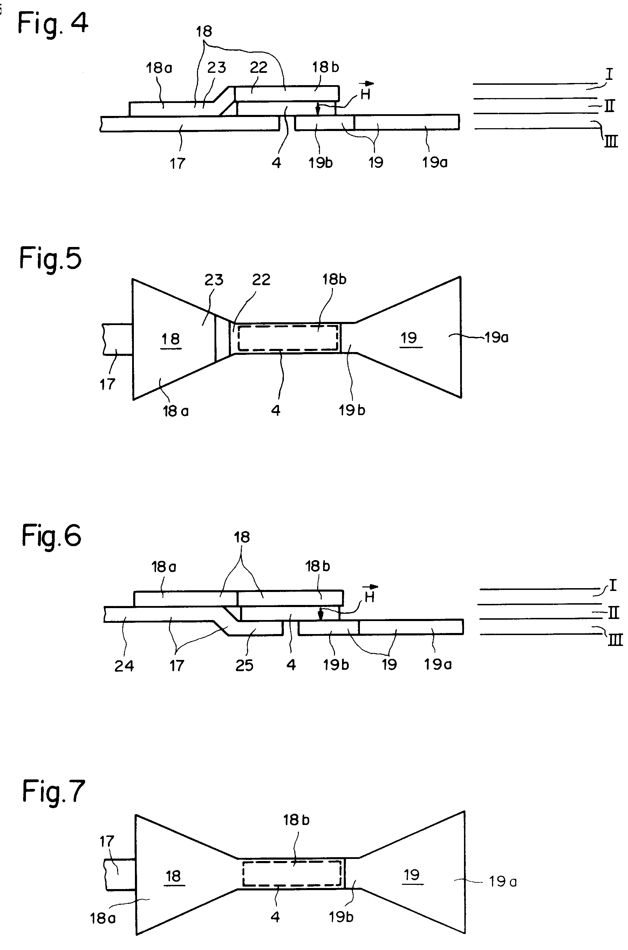

Die drei in den Figuren 4 bis 9 dargestellten Varianten der erfindungsgemässen Anordnung enthalten einen in einem Halbleiter-Chip 4 integrierten Magnetfeldsensor sowie einen ferromagnetischen ersten Magnetfluss-Konzentrator 18 und einen ferromagnetischen zweiten Magnetfluss-Konzentrator 19. Der Halbleiter-Chip 4 ist jeweils montiert auf einem zur erfindungsgemässen Anordnung gehörenden Teil 17 eines anlässlich der Verpackung des Halbleiter-Chips 4 vorhandenen blechförmigen metallischen ersten Leadframes 8. Die beiden Magnetfluss-Konzentratoren 18 und 19 besitzen in der Draufsicht vorzugsweise je eine trichterförmige Gestalt, die jeweils einen trapezförmigen Teil 18a bzw. 19a und einen daran abschliessenden rechteckförmigen Teil 18b bzw. 19b aufweist. In der Darstellung der Zeichnung sind die trichterförmigen Gestalten der beiden Magnetfluss-Konzentratoren 18 und 19 jeweils um 180° verdreht angeordnet. In der Praxis können sie jedoch auch um einen anderen Winkelwert verdreht angeordnet sein. Die rechteckförmigen Teile 18b und 19b der trichterförmigen Gestalten der beiden Magnetfluss-Konzentratoren 18 und 19 sind teilweise überlappend angeordnet. Der Teil 18b des ersten Magnetfluss-Konzentrators 18, der Halbleiter-Chip 4 und der Teil 19b des zweiten Magnetfluss-Konzentrators 19 sind in der angegebenen Reihenfolge mindestens teilweise so aufeinanderliegend angeordnet, dass sie ein drei Schichten I, II und III aufweisendes sandwichförmiges Bauteil 18b;4;19b bilden. Dabei liegt mindestens der magnetfeldempfindliche Teil des Halbleiter-Chips 4 zwischen den beiden Teilen 18b und 19b. Die beiden Magnetfluss-Konzentratoren 18 und 19 sind jeweils ein Teil eines anlässlich der Verpackung des Halbleiter-Chips 4 vorhandenen blechförmigen ferromagnetischen zweiten beziehungsweise dritten Leadframes 20 bzw. 21, die nicht in den Figuren 4 bis 9 sondern nur in der Fig. 10 dargestellt sind. Der Teil 17 des ersten Leadframes 8, auf dem der Halbleiter-Chip 4 montiert ist, ist vorzugsweise in mindestens einer oder zwei der drei Schichten I, II oder III des sandwichförmigen Bauteils 18b;4;19b angeordnet.

In der in den Figuren 4 und 5 dargestellten ersten Variante der erfindungsgemässen Anordnung ist ein zur Anordnung gehörender Teil, z. B. der Teil 18a des ersten Magnetfluss-Konzentrators 18, doppelt abgewinkelt zwecks Bildung eines treppenstufenförmigen Blechteils. Das letztere weist ein erstes Flächenteil 22 und ein zweites Flächenteil 23 auf, die beide parallel versetzt angeordnet sind. Das erste Flächenteil 22 ist mit seiner der Ebene des zweiten Flächenteils 23 zugewandten Seite auf dem Halbleiter-Chip 4 aufliegend in der ersten Schicht I des sandwichförmigen Bauteils 18b;4;19b angeordnet. Das zweite Flächenteil 23 und der Halbleiter-Chip 4 sind in der zweiten Schicht II und ein jeweils zur erfindungsgemässen Anordnung gehörender Teil 17 und 19 des ersten Leadframes 8 und des ferromagnetischen dritten Leadframes 21 sind in der dritten Schicht III jeweils des sandwichförmigen Bauteils 18b;4;19b angeordnet.

In der in den Figuren 6 und 7 dargestellten zweiten Variante der erfindungsgemässen Anordnung ist ein zur erfindungsgemässen Anordnung gehörender Teil 18 des ferromagnetischen zweiten Leadframes 20 in der ersten Schicht I des sandwichförmigen Bauteils 18b;4;19b angeordnet. Der zur erfindungsgemässen Anordnung gehörende Teil 17 des ersten Leadframes 8 ist doppelt abgewinkelt zwecks Bildung eines treppenstufenförmigen Blechteils, welches ein erstes Flächenteil 24 und ein zweites Flächenteil 25 aufweist, die beide parallel versetzt angeordnet sind. Das erste Flächenteil 24 und der Halbleiter-Chip 4 sind in der zweiten Schicht II des sandwichförmigen Bauteils 18b;4;19b angeordnet. Auf einer der Ebene des ersten Flächenteils 24 zugewandten Seite des zweiten Flächenteils 25 ist der Halbleiter-Chip 4 montiert, wobei das zweite Flächenteil 25 und ein zur erfindungsgemässen Anordnung gehörender Teil 19 des ferromagnetischen dritten Leadframes 21 in der dritten Schicht III des sandwichförmigen Bauteils 18b;4;19b angeordnet sind.

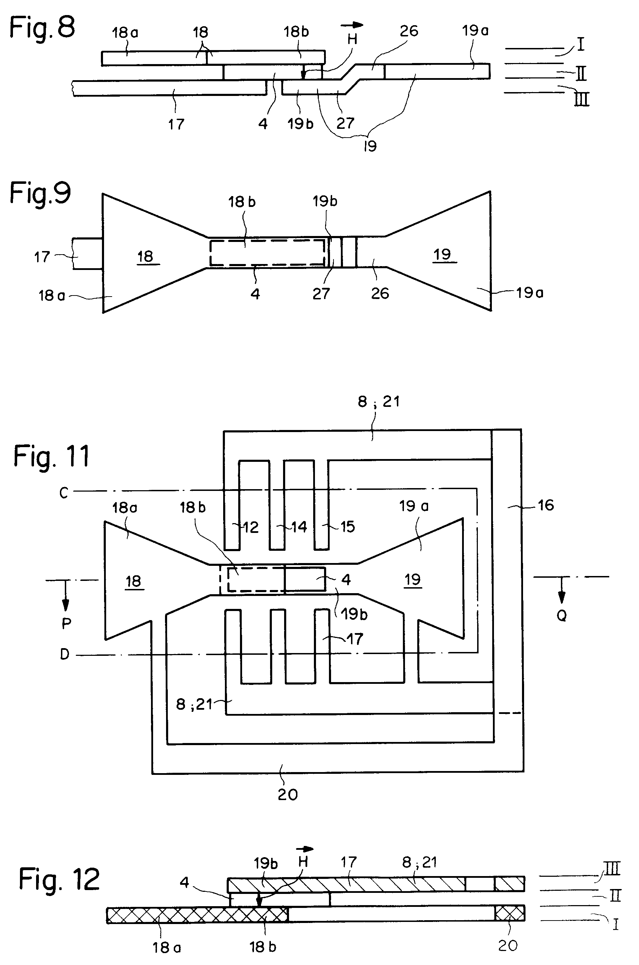

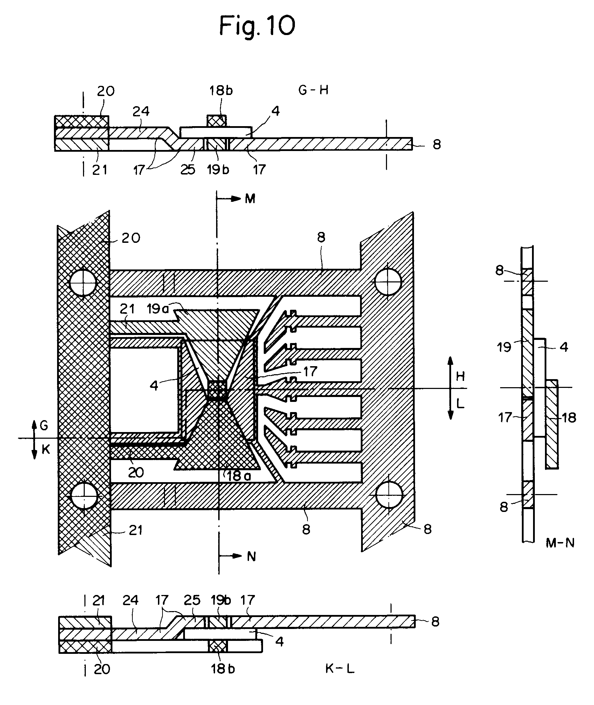

In der in den Figuren 8 und 9 dargestellten dritten Variante der erfindungsgemässen Anordnung ist ein zur erfindungsgemässen Anordnung gehörender Teil 18 des ferromagnetischen zweiten Leadframes 20 in der ersten Schicht I des sandwichförmigen Bauteils 18b;4;19b angeordnet. Ein zur erfindungsgemässen Anordnung gehörender Teil 19b des ferromagnetischen dritten Leadframes 21 ist doppelt abgewinkelt zwecks Bildung eines treppenstufenförmigen Blechteils, welches ein erstes Flächenteil 26 und ein zweites Flächenteil 27 aufweist, die beide parallel versetzt angeordnet sind. Das erste Flächenteil 26 und der Halbleiter-Chip 4 sind in der zweiten Schicht II des sandwichförmigen Bauteils 18b;4;19b angeordnet. Auf einer der Ebene des ersten Flächenteils 26 zugewandten Seite des zur erfindungsgemässen Anordnung gehörenden Teils 17 des ersten Leadframes 8 ist der Halbleiter-Chip 4 montiert, wobei das zweite Flächenteil 27 des zur erfindungsgemässen Anordnung gehörenden Teils 19b des ferromagnetischen dritten Leadframes 21 und der zur erfindungsgemässen Anordnung gehörende Teil 17 des ersten Leadframes 8 in der dritten Schicht III des sandwichförmigen Bauteils 18b;4;19b angeordnet sind.

In der Fig. 4, der Fig. 6 und der Fig. 8 sind vereinfachend das Teil 17 des ersten Leadframes 8 und der als Teil im ferromagnetischen dritten Leadframe 21 enthaltene Magnetfluss-Konzentrator 19 in der Schicht III jeweils nebeneinanderliegend dargestellt. In der Praxis können die Teile 17 und 19 in der Schicht III jedoch auch ineinander verschachtelt angeordnet sein. Dies ist für die zweite Variante der erfindungsgemässen Anordnung anhand der Fig. 10 verdeutlicht, wo aus dem Querschnitt G-H ersichtlich ist, dass das Teil 17 links und rechts vom Teil 19b des Magnetfluss-Konzentrators 19 angeordnet ist, weil das Teil 17 eine U-Form ähnliche Draufsicht besitzt.

Ein Verfahren zum Einbau einer Vielzahl von erfindungsgemässen Anordnungen in je einem Kunststoff-Gehäuse besteht vorzugsweise darin, dass nach einer Montage einer Vielzahl von Halbleiter-Chips 4 auf je einen zugehörigen Teil 17 des ersten Leadframes 8 der ferromagnetische zweite Leadframe 20, der erste Leadframe 8 und der ferromagnetische dritte Leadframe 21 in der angegebenen Reihenfolge sandwichförmig aufeinander gelegt und aneinander gepresst werden bevor anschliessend der Halbleiter-Chip 4 einer jeden Anordnung mitsamt dem zur betreffenden Anordnung gehörenden angrenzenden Teil 17, 18 und 19 der drei Leadframes 20, 8 und 21 durch Spritzen oder Vergiessen im Kunststoff je eines Kunststoff-Gehäuses 5 eingebettet wird, worauf dann die verpackten einzelnen Anordnungen mechanisch voneinander getrennt werden durch Entfernung des überflüssigen und nicht verpackten Teils 16 der drei Leadframes 20, 8 und 21.

Die erfindungsgemässen Anordnungen sind somit ohne Schwierigkeiten in grossen Stückzahlen mit Hilfe einer bei der Herstellung integrierter Schaltungen üblicherweise verwendeten Standard-Montagelinie montierbar und verpackbar, da das Verfahren zum Einbau der erfindungsgemässen Anordnungen in je einem Kunststoff-Gehäuse sich von demjenigen der Standard-Montagelinie nur dadurch unterscheidet, dass bei der Verpackung anstelle eines einzigen Leadframes 8 drei parallel aufeinander liegende und aneinander gepresste Leadframes 8, 20 und 21 verwendet werden. Gegebenenfalls vorstehende treppenstufenförmige Blechteile sind dabei z. B. verschachtelt in Leerräumen eines oder mehrerer benachbarten Leadframes geschoben. Der zur Herstellung der Kunststoffgehäuse 5 unter Druck gegossenene oder gespritzte Kunststoff presst die in der erfindungsgemässen Anordnung verbleibende Teile 18, 19 und 17, mitsamt des auf dem letzteren montierten Halbleiter-Chips 4, der Leadframes 20, 21 und 8 zusammen, so dass nur relativ kleine und genau definierte Luftspalte 3 vorhanden sind. Ausserdem werden dabei alle in der erfindungsgemässen Anordnung vorhandenen Hohlräume mit Kunststoff ausgefüllt.

In den drei ersten Varianten und in der fünften Variante der erfindungsgemässen Anordnung besteht der erste Leadframe 8 aus nichtferromagnetischem Material.

In der in den Figuren 11 und 12 dargestellten vierten Variante der erfindungsgemässen Anordnung ist wieder das sandwichförmige Bauteil 18b;4;19b vorhanden. In dieser Variante besteht der erste Leadframe 8 aus ferromagnetischem Material und übernimmt gleichzeitig die Rolle des dritten Leadframes 21, so dass er hier mit 8;21 bezeichnet wird. Der erste Leadframe 8;21 enthält dabei nicht nur die Montagefläche des Halbleiter-Chips 4 sowie die Anschlussbeine 12, 14 und 15 des Bauelementes, sondern auch den zweiten Magnetfluss-Konzentrator 19, der somit ein Teil des ersten Leadframes 8;21 ist. Der erste Magnetfluss-Konzentrator 18 ist dagegen ein Teil eines blechförmigen ferromagnetischen zweiten Leadframes 20. Die erste Schicht I der Anordnung enthält den in der Anordnung verbleibenden Teil 17 des ersten Leadframes 8;21, während in der zweiten Schicht II der Halbleiter-Chip 4 und in der Schicht III der in der Anordnung verbleibende Teil des zweiten Leadframes 20 angeordnet ist.

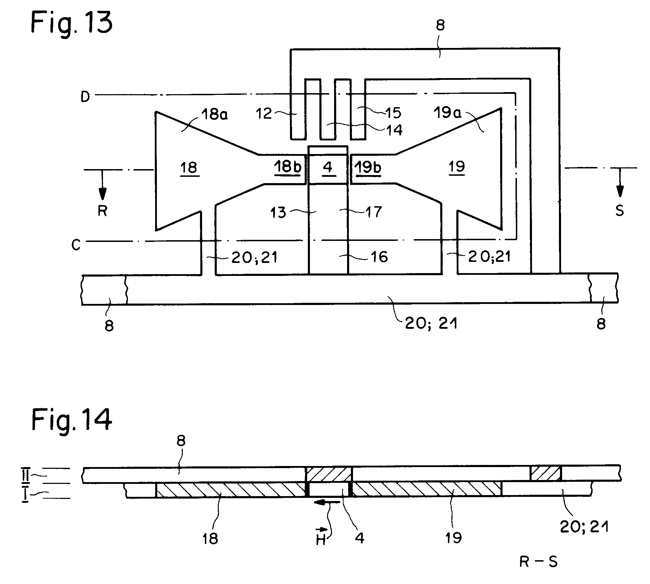

In der in den Figuren 13 und 14 dargestellten fünften Variante der erfindungsgemässen Anordnung sind mindestens der Teil 18b des ersten Magnetfluss-Konzentrators 18, der Halbleiter-Chip 4 und der Teil 19b des zweiten Magnetfluss-Konzentrators 19 in der angegebenen Reihenfolge nebeneinanderliegend in einer einzigen Schicht I angeordnet. Der Leadframe 8 besteht aus nichtferromagnetischem Material und sein in der Anordnung verbleibender Teil 17 ist in einer zur Schicht I parallelen Schicht II enthalten. Die beiden Magnetfluss-Konzentratoren 18 und 19 sind Teil eines einzigen blechförmigen ferromagnetischen zweiten Leadframes 20;21.

Während in den vier ersten Varianten der Magnetfeldsensor ein Magnetfeld H misst, welches in der Nähe der Oberfläche des Halbleiter-Chips 4 senkrecht zur letzteren ausgerichtet ist, misst der Magnetfeldsensor in der fünften Variante ein Magnetfeld H, welches an der gleichen Stelle parallel zur Oberfläche des Halbleiter-Chips 4 wirksasm ist.

In der Fig. 11 und in der Fig. 13 ist je eine Schnittlinie CD dargestellt, entlang welcher die in einem Gehäuse montierten Anordnungen am Ende ihrer Herstellung voneinander getrennt werden.

Das Verfahren zum Einbau einer Vielzahl von Anordnungen der vierten oder fünften Variante in je einem Kunststoff-Gehäuse besteht darin, dass nach der Montage einer Vielzahl von Halbleiter-Chips 4 auf je einen zugehörigen Teil 17 des ersten Leadframes 8 bzw. 8;21 der letztere und der ferromagnetische zweite Leadframe 20 bzw. 20;21 sandwichförmig aufeinander gelegt und aneinander gepresst werden bevor der Halbleiter-Chip 4 einer jeden Anordnung mitsamt eines zur betreffenden Anordnung gehörenden angrenzenden Teils 17, 18 und 19 der beiden Leadframes 20 und 8;21 bzw. 8 und 20;21 im Kunststoff je eines Kunststoff-Gehäuses 5 eingebettet wird, worauf dann die verpackten einzelnen Anordnungen mechanisch voneinander getrennt werden durch Entfernung eines nicht verpackten Teils der beiden Leadframes 20 und 8;21 bzw. 8 und 20;21.

## Patentansprüche

1. Anordnung mit einem in einem Halbleiter-Chip (4) integrierten Magnetfeldsensor sowie einem ferromagnetischen ersten und zweiten Magnetfluss-Konzentrator (18, 19), wobei der Halbleiter-Chip (4) auf einem zur Anordnung gehörenden Teil (17) eines blechförmigen metallischen ersten Leadframes (8 oder 8;21) montiert ist und wobei ein Teil (18b) des ersten Magnetfluss-Konzentrators (18), der Halbleiter-Chip (4) und ein Teil (19b) des zweiten Magnetfluss-Konzentrators (19) jeweils in der angegebenen Reihenfolge entweder mindestens teilweise so aufeinanderliegend angeordnet sind, dass sie ein drei Schichten (I, II, III) aufweisendes sandwichförmiges Bauteil (18b;4;19b) bilden, oder nebeneinanderliegend in einer einzigen Schicht (I) angeordnet sind, dadurch gekennzeichnet, dass die beiden Magnetfluss-Konzentratoren (18, 19) jeweils ein Teil mindestens eines blechförmigen ferromagnetischen zweiten Leadframes (20 bzw. 21, 20 bzw. 8;21, 20;21) sind.

2. Anordnung nach Anspruch 1, dadurch gekennzeichnet, dass der Teil (17) des ersten Leadframes (8 oder 8;21), auf dem der Halbleiter-Chip (4) montiert ist, in einer oder zwei Schichten (III, II oder II und III) der Anordnung angeordnet ist.

3. Anordnung nach Anspruch 2, dadurch gekennzeichnet, dass bei einem Vorhandensein des sandwichförmigen Bauteils (18b;4;19b) und eines nichtferromagnetischen ersten Leadframes (8) die beiden Magnetfluss-Konzentratoren (18, 19) jeweils ein Teil eines blechförmigen ferromagnetischen zweiten beziehungsweise dritten Leadframes (20 bzw. 21) sind.

4. Anordnung nach Anspruch 3, dadurch gekennzeichnet, dass ein zur Anordnung gehörender Teil (18a) des ferromagnetischen zweiten Leadframes (20) doppelt abgewinkelt ist zwecks Bildung eines treppenstufenförmigen Blechteils, welches ein erstes und ein zweites Flächenteil (22, 23) aufweist, die beide parallel versetzt angeordnet sind, dass das erste Flächenteil (22) mit seiner einer Ebene des zweiten Flächenteils (23) zugewandten Seite auf dem Halbleiter-Chip (4) aufliegend in einer ersten Schicht (I) des sandwichförmigen Bauteils (18b;4;19b) angeordnet ist, dass das zweite Flächenteil (23) und der Halbleiter-Chip (4) in einer zweiten Schicht (II) des sandwichförmigen Bauteils (18b;4;19b) angeordnet sind und dass ein jeweils zur Anordnung gehörender Teil (17 bzw. 19) des ersten Leadframes (8) und des ferromagnetischen dritten Leadframes (21) in einer dritten Schicht (III) des sandwichförmigen Bauteils (18b;4;19b) angeordnet sind.

5. Anordnung nach Anspruch 3, dadurch gekennzeichnet, dass ein zur Anordnung gehörender Teil (18) des ferromagnetischen zweiten Leadframes (20) in einer ersten Schicht (I) des sandwichförmigen Bauteils (18b;4;19b) angeordnet ist, dass ein zur Anordnung gehörendes Teil (17) des ersten Leadframes (8) doppelt abgewinkelt ist zwecks Bildung eines treppenstufenförmigen Blechteils, welches ein erstes und ein zweites Flächenteil (24, 25) aufweist, die beide parallel versetzt angeordnet sind, dass das erste Flächenteil (24) und der Halbleiter-Chip (4) in einer zweiten Schicht (II) des sandwichförmigen Bauteils (18b;4;19b) angeordnet sind und dass auf einer der Ebene des ersten Flächenteils (24) zugewandten Seite des zweiten Flächenteils (25) der Halbleiter-Chip (4) montiert ist, wobei das zweite Flächenteil (25) und ein zur Anordnung gehörender Teil (19) des ferromagnetischen dritten Leadframes (21) in einer dritten Schicht (III) des sandwichförmigen Bauteils (18b;4;19b) angeordnet sind.

6. Anordnung nach Anspruch 3, dadurch gekennzeichnet, dass ein zur Anordnung gehörender Teil (18) des ferromagnetischen zweiten Leadframes (20) in einer ersten Schicht (I) des sandwichförmigen Bauteils (18b;4;19b) angeordnet ist, dass ein zur Anordnung gehörender Teil (19b) des ferromagnetischen dritten Leadframes (21) doppelt abgewinkelt ist zwecks Bildung eines treppenstufenförmigen Blechteils, welches ein erstes und ein zweites Flächenteil (26, 27) aufweist, die beide parallel versetzt angeordnet sind, dass das erste Teil (26) und der Halbleiter-Chip (4) in einer zweiten Schicht (II) des sandwichförmigen Bauteils (18b;4;19b) angeordnet sind und dass auf einer der Ebene des ersten Teils (26) zugewandten Seite eines zur Anordnung gehörenden Teils (17) des ersten Leadframes (8) der Halbleiter-Chip (4) montiert ist, wobei das zweite Flächenteil (27) des zur Anordnung gehörenden Teils (19b) des ferromagnetischen dritten Leadframes (21) und der zur Anordnung gehörende Teil (17) des ersten Leadframes (8) in einer dritten Schicht (III) des sandwichförmigen Bauteils (18b;4;19b) angeordnet sind.

7. Anordnung nach Anspruch 2, dadurch gekennzeichnet, dass bei einem Vorhandensein des sandwichförmigen Bauteils (18b;4;19b) der erste Leadframe (8;21) aus ferromagnetischem Material besteht, dass der erste Magnetfluss-Konzentrator (18) ein Teil des blechförmigen ferromagnetischen zweiten Leadframes (20) ist und dass der zweite Magnetfluss-Konzentrator (19) ein Teil des ersten Leadframes (8;21) ist.

8. Anordnung nach Anspruch 2, dadurch gekennzeichnet, dass, wenn ein Teil (18b) des ersten Magnetfluss-Konzentrators (18), der Halbleiter-Chip (4) und ein Teil (19b) des zweiten Magnetfluss-Konzentrators (19) mindestens teilweise nebeneinanderliegend in einer einzigen Schicht (I) angeordnet sind, beim Vorhandensein eines nichtferromagnetischen erste Leadframes (8) die beiden Magnetfluss-Konzentratoren (18, 19) Teil eines einzigen blechförmigen ferromagnetischen zweiten Leadframes (20;21) sind.

9. Verfahren zum Einbau einer Vielzahl von Anordnungen nach einem der Ansprüche 1 bis 6 in je einem Kunststoff-Gehäuse, dadurch gekennzeichnet, dass nach einer Montage einer Vielzahl von Halbleiter-Chips (4) auf je einen zugehörigen Teil (17) des ersten Leadframes (8) ein ferromagnetischer zweiter Leadframe (20), der erste Leadframe (8) und ein ferromagnetischer dritter Leadframe (21) in der angegebenen Reihenfolge sandwichförmig aufeinander gelegt und aneinander gepresst werden bevor der Halbleiter-Chip (4) einer jeden Anordnung mitsamt eines zur betreffenden Anordnung gehörenden angrenzenden Teils (17, 18, 19) der drei Leadframes (20, 8, 21) im Kunststoff je eines Kunststoff-Gehäuses (5) eingebettet wird, worauf dann die verpackten einzelnen Anordnungen mechanisch voneinander getrennt werden durch Entfernung eines nicht verpackten Teils der drei Leadframes (20, 8, 21).

10. Verfahren zum Einbau einer Vielzahl von Anordnungen nach Anspruch 7 oder 8 in je einem Kunststoff-Gehäuse, dadurch gekennzeichnet, dass nach einer Montage einer Vielzahl von Halbleiter-Chips (4) auf je einen zugehörigen Teil (17) des ersten Leadframes (8 oder 8;21) der letztere und ein ferromagnetischer zweiter Leadframe (20 oder 20;21) sandwichförmig aufeinander gelegt und aneinander gepresst werden bevor der Halbleiter-Chip (4) einer jeden Anordnung mitsamt eines zur betreffenden Anordnung gehörenden angrenzenden Teils (17, 18, 19) der beiden Leadframes (20, 8;21 oder 8, 20;21) im Kunststoff je eines Kunststoff-Gehäuses (5) eingebettet wird, worauf dann die verpackten einzelnen Anordnungen mechanisch voneinander getrennt werden durch Entfernung eines nicht verpackten Teils der beiden Leadframes (20, 8;21 oder 8, 20;21).
